# EUROPEAN PATENT SPECIFICATION

(11) **EP 1 157 852 B1**
(45) Date of publication and mention of the grant of the patent: **14.04.2004**
(21) Application number: 00110550.1
(22) Date of filing: 17.05.2000
(51) Int. Cl.: B41M 7/00, B41M 5/00

(54) **Ink receptor sheet and its process of use**
Tintenempfangsblatt bzw. sein Anwendungsverfahren
Feuille réceptrice d'encre et procédé pour son utilisation

(43) Date of publication of application: 28.11.2001
(73) Proprietor: DU PONT DE NEMOURS (DEUTSCHLAND) GMBH, 61352 Bad Homburg (DE); E.I. du Pont de Nemours and Company, Wilmington, DE 19898 (US)
(72) Inventor: Sondergeld, Manfred, Dr., 63165 Mühlheim (DE); Strüwe, Volker, 63128 Dietzenbach (DE)

(56) References cited:
- EP-A- 0 782 931
- WO-A-95/06564
- US-A- 5 766 398
- US-A- 5 795 425
- US-A- 5 984 467

## Description

### FIELD OF INVENTION

The invention relates to an ink receptor sheet, a printing system comprising such an ink receptor sheet and a transfer element, a process for preparing an image on a permanent substrate by formation of an ink image, and an imaged article made by such a process.

### BACKGROUND OF INVENTION

Ink jet printing is a well known process in the art to make multicolor images. It is a non-impact method for recording information in response to an electronic signal, such as that generated by a computer. In this process, ink droplets are emitted from a nozzle and deposited on substrates, mainly paper or polymer films and sheets, to form an ink image. To achieve high quality images in ink jet printing, the substrate is usually coated with at least one layer that rapidly absorbs the ink. For the inks are mainly composed of water and a colorant, such coating formulations are hydrophilic and contain appropriate absorptive materials.

It is also possible to transfer the ink image present on the ink receiving layer of an ink receiving sheet, comprising a temporary support and an ink receiving layer, to a permanent substrate. After peeling of the temporary support, the image is transferred to the permanent substrate.

Alternatively, the imaged ink receptor sheet may first be laminated to a transfer element. Then the temporary support of the ink receptor sheet is removed, the imaged ink receiving layer on the transfer element is then laminated to the desired permanent substrate, and finally the transfer element is removed.

Ink jet printing materials and transfer processes are known from US 5,023,129, US 5,141,797, and US 5,984,467. Ink receptor sheets which provide ink images with improved durability are known from US 5,429,860 and US 5,537,137. These materials contain special compounds in the ink receiving layer which compounds are crosslinked by heat, by actinic radiation, or by chemical treatment after ink jet printing. Another method to provide durable ink jet images is disclosed in US 5,766,398 and its equivalent WO 95 06564. This method provides images with a protective layer on the ink image by using an ink receptor sheet comprising a temporary support, a polymeric film, for example a polyester film, and an ink receiving layer. After applying an image by ink jet printing to the ink receiving layer, a substrate comprising an adhesive layer is laminated to the imaged ink receptor sheet, and the temporary support of the ink receptor sheet is removed, whereby the polymeric film is revealed as a protective layer of the ink image.

There are still problems with the ink jet materials and processes of the prior art, such as they often have narrow handling latitude during the required lamination and peeling steps. Either high lamination temperatures and slow lamination speeds are necessary or it is difficult to separate the right layers in the peeling steps to get the desired end result.

### SUMMARY OF INVENTION

Therefore, it was an objective of the present invention to enhance the handling latitude during the required lamination and peeling steps of ink jet printing processes and/or to provide durable and resistant images made by such ink jet printing processes.

In a first aspect, this objective is achieved by an ink receptor sheet comprising a first temporary support and an ink receiving layer, characterized in that it additionally comprises a photopolymerizable layer comprising at least one polymeric binder, at least one photopolymerizable, ethylenically unsaturated monomer, and at least one photoinitiator or photoinitiator system between the first temporary support and the ink receiving layer.

In a second aspect, the invention is directed to an ink jet printing system comprising in combination an ink receptor sheet and a transfer element comprising a second temporary support and an adhesive layer.

In a third aspect, the invention is directed to a process for preparing an image on a permanent substrate comprising the steps of:
(a) imagewise applying at least one ink image on an ink receptor sheet, wherein the ink receptor sheet comprises, in order:
   (1) a first temporary support,
   (2) a photopolymerizable layer comprising at least one polymeric binder, at least one photopolymerizable, ethylenically unsaturated monomer, and at least one photoinitiator or photoinitiator system,
   (3) and an ink receiving layer, and whereby the ink image is adjacent the ink receiving layer;
(b) contacting, typically laminating, the imaged ink receptor sheet to a transfer element comprising:
   (I) a second temporary support,
   (II) and an adhesive layer, whereby the ink image is adjacent the adhesive layer;
(c) removing the second temporary support to reveal the adhesive layer on top of the imaged ink receptor sheet,
(d) contacting, typically laminating, the imaged ink receptor sheet with a permanent substrate, whereby the adhesive layer is adjacent the permanent substrate,
(e) overall exposing with actinic radiation the permanent substrate and imaged ink receptor sheet sandwich through the first temporary support, and
(f) removing the first temporary support to reveal the final image on the permanent substrate, wherein the image is encased between the ink receiving layer and the adhesive layer. Typically an ink jet printer is used for the imagewise application of the image.

In a fourth aspect, the invention is directed to an imaged article comprising a permanent substrate, an adhesive layer, an image, typically an ink jet image, an ink receiving layer, and a protective layer derived from a photopolymerizable layer comprising at least one polymeric binder, at least one photopolymerizable, ethylenically unsaturated monomer, and at least one photoinitiator or photoinitiator system.

### DETAILED DESCRIPTION OF INVENTION

The present invention provides an ink receptor sheet which enhances the handling latitude during the required contacting, typically lamination, and peeling steps of ink jet printing transfer processes. It is not necessary to use special coated or treated synthetic resin films as temporary supports for the ink receptor sheet. No adhesion failure occurs during the peeling processes of temporary supports, even with non-pretreated temporary supports. Therefore, no edge lifting of layers or partial peel off of layer surfaces damaging the final images results. Furthermore, the present invention provides durable and resistant images made by such ink jet printing processes, and simultaneously provides a protective layer for the final images.

### Ink receptor sheet

The ink receptor sheet comprises a temporary support, a photopolymerizable layer, and an ink receiving layer.

### Temporary support:

Suitable supports are, for example, synthetic resin films of polyethylene, polypropylene, polyamides, or polyesters. Polyethylene terephthalate films are particularly preferred. Supports having smooth or rough surfaces can be used. Support films having release layers or surfaces treated by electrical discharge are also suitable. The thickness of the support is usually at least about 12 µm, typically about 20 - 200 µm, more typically about 75 - 150 µm.

### Photopolymerizable layer:

Preferably, the photopolymerizable layer in its non-photopolymerized state shows high adhesion to the ihk receiving layer and the first temporary support, whereas the photopolymerizable layer in its photopolymerized state shows high adhesion to the ink receiving layer and low adhesion to the first temporary support.

The photopolymerizable layer comprises at least one polymeric binder, at least one photopolymerizable, ethylenically unsaturated monomer, and at least one photoinitiator or photoinitiator system.

Especially, the photopolymerizable layer comprises at least one polymer selected from the group consisting of polyvinylformal, polyvinyl butyral, polyvinyl alcohol, polyvinyl acetate, polyurethane esters, polyacrylates containing carboxylic groups, polymethacrylates, and copolymers of (meth)acrylic acid with (meth)acrylic esters, (meth)acrylic amides, vinyl compounds, styrene, and butadiene. Preferred are polyvinyl alcohols and copolymers of alkyl methacrylates, e.i. methyl methacrylate, ethyl methacrylate, butyl methacrylate, and alkyl acrylates, e.i. methyl acrylate, ethyl acrylate, butyl acrylate. Especially mixtures of such polymers are suitable. For aqueous coating solutions polymer latices are used. Also suitable are the crosslinked polymers disclosed in US 4,892,802.

Conventional photopolymerizable, ethylenically unsaturated monomers may be used in the ink receptor sheets of this invention. Especially those disclosed in US 4,892,802 are typical. Typically used are acrylic and methacrylic acid esters of polyols, such as, diethylene glycol diacrylate, 1,3-propanediol dimethacrylate, 1,5-pentanediol dimethacrylate, trimethylol propane trimethacrylate, bisacrylates or methacrylates of bisphenol A or its alkoxylated derivatives, and pentaerythritol tetraacrylate or methacrylates. More typically, the photopolymerizable layer comprises at least one monomer selected from the group consisting of trimethylol propane trimethacrylate, bisacrylates or methacrylates of bisphenol A, and pentaerythritol tetraacrylate or methacrylates.

As a photoinitiator or photoinitiator system, practically all compounds known for this purpose can be used. Typically compounds and systems are disclosed in US 4,892,802. Especially preferred are diacetyl, benzil, benzil dimethyl ketal, benzoin, benzoin methyl or ethyl ether, a combination of Michler's ketone and benzophenone, and systems of substituted thioxanthones and tertiary amines.

In addition to the main components described in the foregoing, the photopolymerizable layer of the present invention may comprise conventional additives like, for example, UV absorbers, thermal stabilizers, plasticizers,, and fillers. In particular, the addition of fillers, such as, for example, silicates, aluminium oxides, and silicon dioxides are advantageous. Pyrogenic and precipitated silicic acids are preferred. Fillers are present in an amount of from about 0 to about 15 % by weight, typically 0 to 10 % by weight, based on the total weight of the layer.

The photopolymerizable layer of the invention generally comprises about 25 to about 75 % by weight, typically about 35 to about 50 % by weight of the polymeric binder; about 10 to about 60 % by weight, typically about 15 to about 50 % by weight of the photopolymerizable, ethylenically unsaturated monomer; about 0.1 to 10 % by weight, typically about 1 to about 5 % by weight of the photoinitiator or photoinitiator system; and about 0 to about 10 % by weight, typically about 1 to about 10 % by weight of additives; based on the total weight of the photopolymerizable layer.

The photopolymerizable layer of this invention can be prepared by generally known coating methods. For this purpose, aqueous as well as organic coating solutions can be used, as, for example, methylene chloride, toluene/methanol mixtures, or other mixtures of aromatic solvents and alcohols, esters, or ketones. Preferably, the photopolymerizable layer is made by emulsion coating. Subsequently, the coated layer is dried. The coating weight of the photopolymerizable layer is about 25 to about 80 mg/dm², typically about 40 to about 60 mg/dm².

### Ink receiving layer

In general, all ink receiving materials of the state of the art, including those which are composed of at least two layers, can be used for preparing the ink receiving layer of this invention. Suitable ink receiving materials are described in US 5,023,129, US 5,141,797, US 5,984,467, US 5,429,860 and US 5,537,137. Preferably, the ink receiving layers of the present invention are non-tacky. The ink receiving layer of the present invention typically comprises at least one hydrophilic polymer. More typically, the ink receiving layer comprises at least one polymer selected from the group consisting of homo- and copolymers of vinyl alcohol and/or pyrrolidone; homo- and copolymers of acrylic acid, methacrylic acid, and/or maleic acid and /or maleic acid anhydride, and/or their metal salts and/or their amine salts; gelatine, and starch. Especially mixtures of polyvinyl alcohols and/or copolymers of maleic acid or maleic acid anhydride with comonomers like methyl vinyl ether, are used. The hydrophilic polymer generally will be water-soluble in order that it may be applied using conventional aqueous coating techniques.

Additional compounds of the ink receiving layer may be, for example, UV absorbers, coating additives, plasticizers, and fillers. When polymers comprising acid groups are used, preferably compounds which neutralize these acid groups are added to adjust the pH value. Typically, amines are used; especially tertiary amines like triethanol amine, are used. In particular, the addition of fillers, such as, for example, silicates, aluminium oxides, and silicon dioxides is advantageous. Pyrogenic and precipitated silicic acids are preferred. Fillers are present in an amount of from about 0 to about 15 % by weight, typically about 0 to about 10 % by weight, based on the total weight of the layer.

The ink receiving layer of this invention can be prepared by generally known coating methods. Subsequently, the coated layer is dried. The coating weight of the ink receiving layer is about 50 to about 150, typically about 60 to about 100 mg/dm²

### Transfer element

The transfer element of the present invention comprises a temporary support and an adhesive layer. Suitable supports are, for example, synthetic resin films of polyethylene, polypropylene, polyamides, or polyesters. Polyethylene terephthalate films particularly preferred. Supports having smooth or rough surfaces can be used. Support films having release layers or surfaces treated by electrical discharge are also suitable. The thickness of the support is usually at least about 12 µm, typically about 20 - about 130 µm, more typically at about 50 to about 100 µm.

The adhesive layer may comprise at least one thermoplastic polymer, for example at least one polymer selected from the group consisting of acrylate and methacrylate copolymers, vinyl acetate copolymers, and polyamides. Preferably the adhesive layer of the transfer element comprises at least one crystalline polymer. Especially preferred are polycaprolactones. The adhesive layer can also contain additives, such as, for example, surfactants and fillers. In particular, addition of fillers, such as, for example, silicates, aluminium oxides, and silicon dioxides are advantageous. Pyrogenic and precipitated silicic acids are preferred. Fillers are present in an amount of from about 0 to about 15 % by weight, typically about 0 to about 10 % by weight, based on the total weight of the layer.

The transfer element of this invention can be prepared by known methods. For this purpose, coating solutions for forming the adhesive layer can be coated on the supports from currently available solvents, preferably organic solvents, such as, for example, methylene chloride, toluene/methanol mixtures, or other mixtures of aromatic solvents and alcohols, esters, or ketones and subsequently dried. The coating weight of the adhesive layer is about 30 to about 100 mg/dm², typically about 40 to about 80 mg/dm².

### Inks

The inks used in the ink jet printing process of the present invention are well known in the art. The ink compositions usually comprise a carrier medium, normally water, and a colorant, which may be a dye or a pigment dispersion. Furthermore, additives like detergents, thickeners, organic solvents, etc. may be present. Suitable ink compositions are described in US 5,984,467 and US 5,537,137.

### Permanent substrate

The imaged ink receptor sheet of the present invention may be applied to many types of permanent substrates by use of the adhesive layer of the transfer element. Some permanent substrates include paper, polymer foils, metal, or card board.

### Applications

The ink receptor sheet provided by the present invention may receive ink printed by conventional ink jet printers, such as thermal or bubble jet printers, piezoelectric printers, continuous flow printers, or valve jet printers. After the ink is printed on the ink receiving layer of the ink receptor sheet, the printed sheet is air dried.

Then a transfer element is contacted to the imaged ink receptor sheet. Typically, it is laminated with a conventional laminator, e.g. an EasySprint® Desktop laminator (E.I du Pont de Nemours& Company, Wilmington, Del.). The temperature of the laminator rollers is usually at least about 80 °C, typically about 90 to about 130 °C.

The temporary support of the transfer element is peeled off manually or automatically, whereby the adhesive layer of the transfer element is transferred to the imaged ink receptor sheet. The temporary support is peeled off preferably after cooling to room temperature. More typical is an additional hold time of 1 - 5 min.

The imaged ink receptor plus the adhesive layer from the transfer element are then contacted, typically laminated, like in the previous contact/lamination step to a permanent substrate. After this contact, typically lamination, the photopolymerizable layer of the ink receptor sheet and permanent substrate sandwich is overall exposed with actinic radiation through the temporary support of the ink receptor sheet for about 10 to about 30 sec. Some examples of suitable radiation sources are xenon lamps, mercury vapor lamps and carbon-arcs, laser fluorescent lamps with fluorescent materials emitting UV radiation and electronic flash devices.

Afterwards, the temporary support of the ink receptor sheet is easily peeled off to reveal the final ink jet image, encased between the adhesive and the ink receiving layers, and protected by the photopolymerized layer, on the permanent substrate. The temporary support of the ink receptor sheet is peeled off manually or automatically, typically after cooling to room temperature. More typical is an additional hold time of about 1 to about 5 min.

The overall exposure of the photopolymerizable layer of the ink receptor sheet can also be carried out before instead of after contacting, typically laminating, the imaged ink receptor sheet plus the adhesive layer from the transfer element to the permanent substrate.

Furthermore, it is possible to contact, typically laminate, a photosensitive layer to the imaged ink receiving layer of the ink receptor sheet under the same process conditions as described above before a transfer element is applied. Suitable photosensitive materials are positive- and negative-working materials as those disclosed in US 3,649,268, US 4,174,216, US 4,892,802, and US 4,053,313. Typically, photosensitive materials are those of US 4,892,802.

This photosensitive layer is imagewise exposed with actinic radiation by using radiation sources like those previously described to produce tacky and non-tacky areas. The photosensitive layer may comprise a strippable base on its top which may be stripped before or after imagewise exposure. Suitable materials for such bases are synthetic resin films of polyethylene, polypropylene, polyamides, or polyesters. Then a toner is applied to the tacky areas of the imagewise exposed photosensitive layer. Powder toners as well as pigmented foils may be used. Such toner materials are disclosed in US 3,649,268; US 3,620,726; 3,909,282; and US 5,372,910 and US 5,427,894. These additional steps of applying a photosensitive layer, imagewise exposing it, and adding a toner may be repeated at least twice. Then the further steps of the transfer process according to the present invention are conducted as described above.

It is also possible to laminate an imaged ink receptor sheet of the present invention to an adhesive coated permanent substrate without transferring the imaged ink receptor sheet to a transfer element. All further process steps are conducted as described previously. The adhesive coated permanent substrate preferably comprises an adhesive layer like that of the transfer element. A transfer element of this invention may be laminated to any substrate to form this adhesive layer.

### Industrial Utility

The ink receptor sheet, the ink jet printing system comprising the ink receptor sheet and a transfer element as well as the processes of the present invention have commercial utility for ink jet printing technologies, especially with aqueous ink dispersions. Pictorial as well as textured information may be printed. For multicolored images, yellow, cyan, magenta, and black inks may be used to advantage. Applications include desktop publishing, as well as wide format applications such as the printing of signs, banners, and the like. High quality images may be printed on a broad variety of substrates.

### EXAMPLES

The following examples illustrate the invention, but do not limit it. Parts and percentages are by weight, unless otherwise stated. The average molecular weights of the polymers are given as weight average (Mw). Percent hydrolysis is given as mole percent hydrolysis of acetate groups on dry basis.

### Example 1:

### (I) Ink receptor sheet

### Photopolymerizable layer

7 g of Elvanol® 52-22 (E.I du Pont de Nemours& Company, Wilmington, Del.; polyvinyl alcohol, 87 - 89 % hydrolysis, viscosity of aqueous solution (4 % solids) at 20 °C by Hoeppler falling ball method: 21 - 26 mPa s) were dissolved in 96.4 g water 3.5 g Irgacure® 651 (benzil dimethyl ketal) were dissolved in 25.9 g TMPTMA (trimethylol propane trimethacrylate). This monomer/initiator solution was added to the Elvanol® solution and emulsified with a high speed mixer for 5 min. The emulsion was diluted with 150 g water and 67.2 g Plextol® D540 (Polymer Latex, Marl, Germany; aqueous dispersion of acrylic polymer based on methyl methacrylate and n-butyl acrylate, Brookfield viscosity 3 - 10 Pa s, 50 % of solids) were added and mixed under moderate stirring. The emulsion/dispersion was coated with a doctor knife onto a 125 µm thick untreated polyester base which formed the temporary support of the ink receptor sheet and dried at room temperature. The resulting coating weight was 60 mg/dm².

### Ink receiving layer

3.6g Gantrez® S97 (ISPEurope, Guildford, GB; free acid of methyl vinyl ether/maleic anhydride copolymer, about Mw 2 200 00) were dissolved in 182.5g water. 2.13g Ludox® LS (E.I du Pont de Nemours& Company, Wilmington, Del.; colloidal silica in water, 30 % of solids) were added and mixed. 2.8 g triethanolamine were added and mixed. 8.96 g Elvanol® 52-22 were added and stirred until dissolved. The final solution had a pH of 5.3 and a viscosity of 660 cP. The solution was coated with a Meyer bar onto the above mentioned photopolymerizable layer and dried at room temperature. The coating weight of the ink receiving layer was 80 mg/dm².

### Transfer element

10.56 g Capa® 650 (Solvay Interox, Warrington, GB; polycaprolactone Mw 50 000, melting range Tm 5 8 - 60 °C, glass transition temperature range Tg -60 to -70 °C) were dissolved in 80.1 g toluene and 8.9 g methanol. 0.44g Acematt® OK607 (Degussa Hüls; Germany; precipitated silica, 2 µm particle size) were added and dispersed under vigorous stirring. The solution was coated with a doctor knife onto a 50 µm thick release treated polyester base which formed the temporary support of the transfer element and dried at room temperature to form an adhesive layer. The coating weight was 60 mg/dm².

### Process of use

A wrong reading 4 - color image was printed onto the ink receptor sheet with an AX-4 Digital Cromalin® ink jet printer (E.I du Pont de Nemours & Company, Wilmington, Del.). A very uniform print with complete ink acceptance and no image disturbances or "beading" was achieved. Only slight surface tackiness was observed directly after printing in areas where all 4 colors had been printed 100 % on top of each other. After 10 min. drying at room temperature the entire surface was found to be non-tacky.

The transfer element was laminated to the imaged ink receptor sheet with an EasySprint® Desktop laminator (E.I du Pont de Nemours & Company, Wilmington, Del.) at 115 °C roller temperature wherein the adhesive layer of the transfer element adhered to the imaged ink receiving layer. After cooling to room temperature and a 1 min. hold time the temporary support of the transfer element was peeled off without any residues. The adhesive layer of the transfer element was completely transferred to the printed ink receptor sheet without any adhesion failure or edge lifting at the photopolymerizable layer/temporary support interface of the ink receptor sheet.

The ink receptor sheet plus the adhesive layer of the transfer element were laminated to a 120 g/m² Ikonorex® paper (Ikono Zanders, Germany) with an EasySprint® Desktop laminator at 115 °C roller temperature. After the lamination the photopolymerizable layer was overall exposed through the temporary support of the ink receptor sheet for 15 sec in a commercial 1000 W UV exposure frame to render the photopolymerizable layer non-tacky. After the exposure the temporary support of the ink receptor sheet was easily peeled off without any damage of the surface or any adhesion failure between the layers or to the paper substrate.

### Example 2

### Ink receptor sheet

### Photopolymerizable layer

3.5 g Elvanol® 52-22 were dissolved in 46.8 g water. 1.75 g Irgacure® 651 were dissolved in 12.95 g TMPTMA. The monomer/initiator solution was emulsified in the Elvanol® solution as described in Example 1. The emulsion was diluted with 40 g water and 35 g Primal® CS-4000 (Röhm & Haas, Germany; aqueous dispersion of acrylic polymer, 48% of solids) was stirred in. The emulsion/dispersion was coated with a doctor knife onto a 125 µm thick untreated polyester base which formed the temporary support of the ink receptor sheet and dried at room temperature. The coating weight was 60 mg/dm².

### Ink receiving layer

3.19 g Gantrez® AN119 (ISPEurope, Guildford, GB; methyl vinyl ether/maleic anhydride copolymer, Mw about 216 000) were dissolved in 133.5g water at 80 °C. 9.9g Elvanol® 52-22 were added and dissolved at 80 °C. After cooling to room temperature 3.05 g triethanolamine were added and mixed. The final solution had a pH of 5.8 and a viscosity of 380 cP. The solution was coated onto the photopolymerizable layer and dried as described in example 1. The coating weight was 60 mg/dm².

### Process of use as described in Example 1

After printing onto the ink receptor sheet, the surface was only slightly tacky over areas where all 4 colors had been printed 100% on top of each other. After laminating the transfer element to the imaged ink receptor sheet and peeling the temporary support of the transfer element, the photopolymerizable layer was overall exposed. The imaged and exposed ink receptor sheet with the adhesive layer on top was then laminated to a 100 µm thick corona treated polyethylene foil. The temporary support of the ink receptor sheet was peeled off easily without any damage of the surface or any adhesion failure between the layers or to the polyethylene foil.

### Example 3

### Ink receptor sheet

### Photopolymerizable layer

12 g Elvacite® 2044 (E.I du Pont de Nemours & Company, Wilmington, Del.; butyl methacrylate copolymer), 7 g TMPTA andl g Irgacure® 651 were dissolved in 80 g toluene. The solution was coated with a doctor knife onto a 125 µm thick untreated polyester base which formed the temporary support of the ink receptor sheet and dried at room temperature. The coating weight was 40 mg/dm².

### Ink receiving layer

3.19 g Gantrez ®AN119 were dissolved in 133.5 g water at 80 °C.9.9 g Moviol® 4-88 (Clariant GmbH, Germany; polyvinyl alcohol, 88 % hydrolysis, viscosity 4 mPa s) were added and dissolved at 80 °C. After cooling to room temperature 3.05 g triethanolamine were added and mixed. The final solution had a pH of 5.4 and a viscosity of 140 cP. The solution was coated onto the photopolymerizable layer and dried as described in example 1. The coating weight was 80 mg/dm².

### Process of use as described in Example 1

After printing onto the ink receptor sheet, the surface was only slightly tacky over areas where all 4 colors had been printed 100 % on top of each other. After laminating the transfer element to the printed ink receptor sheet and peeling the temporary support of the transfer element, the imaged ink receptor sheet with the adhesive layer on top was laminated to a 200 µ thick aluminum foil. After the overall exposure ofthe photopolymerizable layer the temporary support of the ink receptor sheet was easily peeled off without any damage of the surface or any adhesion failure between the layers or to the aluminum foil.

### Example 4

A wrong reading 4 - color image was printed as described in Example 1 onto an ink receptor sheet according to Example 1. Then a positive Cromalin® sheet (E.I du Pont de Nemours & Company, Wilmington, Del.), after removal of its cover sheet, was laminated on top of the imaged ink receiving layer with an EasySprint® Desktop laminator (E.I du Pont de Nemours & Company, Wilmington, Del.) at 115 °C roller temperature. This layer was imagewise exposed through its base to provide tacky and non-tacky areas. The base was peeled off, and a white powder toner was applied to the tacky areas to provide a background image for the ink jet image. The transfer element was then laminated to the imaged ink receptor sheet as described in Example 1 and the temporary support of the transfer element was peeled off without any residues. The adhesive layer of the transfer element was completely transferred to the printed ink receptor sheet without any adhesion failure or edge lifting at the photopolymerizable layer/temporary support interface of the ink receptor sheet.

The imaged ink receptor sheet plus the toned Cromalin® layer plus the adhesive layer of the transfer element were laminated to a clear polyester base with an EasySprint® Desktop laminator at 115 °C roller temperature. After the lamination the photopolymerizable layer was overall exposed through the temporary support of the ink receptor sheet for 15 sec in a commercial 1000 W UV exposure frame to render the photopolymerizable layer non-tacky. After the exposure the temporary support of the ink receptor sheet was easily peeled off without any damage of the surface or any adhesion failure between the layers or to the paper receptor.

### Comparative Example 1

The solution for the ink receiving layer of Example 1 was directly coated onto a 125 µm thick untreated polyester base which formed the temporary support of the ink receptor sheet as described in Example 1. The coating weight was 80 mg/dm².

A wrong reading 4 - color image was printed onto this ink receptor sheet as described in example 1 and basically the same results were obtained as described in Example 1.

The same transfer element as in Example 1 was laminated to the imaged ink receptor sheet with an EasySprint® Desktop laminator at 115 °C roller temperature. After cooling to room temperature and a 1 min hold time, an attempt was made to peel off the temporary support of the transfer element. However, because of the insufficient adhesion of the imaged ink receiving layer to the temporary support, the imaged ink receiving layer was transferred to the transfer element. Because of this adhesion failure the printed image could not be transferred to a permanent substrate.

### Comparative Example 2

The solution for the ink receiving layer of Example 1 was directly coated onto a 100 µm thick corona treated polyester base which formed the temporary support of the ink receptor sheet as described in Example 1. The coating weight was 80 mg/dm².

A wrong reading 4 - color image was printed onto this ink receptor sheet as described in Example 1 and basically the same results were obtained as in Example 1.

The transfer element was laminated to the imaged ink receptor sheet with an EasySprint® Desktop laminator at 115 °C roller temperature. After cooling to room temperature and a 1 min. hold time, the temporary support of the transfer element was peeled off without any residues. The adhesive layer of the transfer element was completely transferred to the imaged ink receptor sheet without any adhesion failure or edge lifting at the ink receiving layer/temporary support interface.

The ink receptor sheet plus the adhesive layer of the transfer element were laminated to a 120 g/m2 Ikonorex® paper with an EasySprint® Desktop laminator at 115 °C roller temperature. After cooling to room temperature and a 1min. hold time, the temporary support of the ink receptor sheet could barely be peeled off. The surface of the ink receiving layer was damaged and some areas of the printed image were pulled off with the temporary support. The final proof was unusable.

## Claims

1. An ink receptor sheet comprising, in order:
(1) a first temporary support, and
(2) an ink receiving layer,
**characterized in that** it further comprises a photopolymerizable layer comprising at least one polymeric binder, at least one photopolymerizable, ethylenically unsaturated monomer, and at least one photoinitiator or photoinitiator system between the first temporary support and the ink receiving layer.

2. The ink receptor sheet according to claim 1,
**characterized in that** the photopolymerizable layer comprises at least one polymeric binder selected from the group consisting of polyvinylformal, polyvinyl butyral, polyvinyl alcohol, polyvinyl acetate, polyurethane esters, polyacrylates containing carboxylic groups, polymethacrylates, and copolymers of (meth)acrylic acid with (meth)acrylic esters, (meth)acrylic amides, vinyl compounds, styrene, and butadiene.

3. The ink receptor sheet according to claims 1 - 2,
**characterized in that** the photopolymerizable layer comprises at least one monomer selected from the group consisting of trimethylol propane trimethacrylate, bisacrylates or methacrylates of bisphenol A or its alkoxylated derivatives, and pentaerythritol tetraacrylate or methacrylate.

4. The ink receptor sheet according to claims 1 - 3,
**characterized in that** the ink receiving layer comprises at least one hydrophilic polymer.

5. The ink receptor sheet according to claims 1 - 4,
**characterized in that** the ink receiving layer comprises at least one polymer selected from the group consisting of homo- and copolymers of vinly alcohol and/or pyrrolidone; homo- and copolymers of acrylic acid, methacrylic acid, and/or maleic acid and/or maleic acid anhydride, and/or their metal salts and/or their amine salts; gelatine, and starch.

6. An ink jet printing system comprising in combination:
(I) an ink receptor sheet according to claims 1 - 5, and
(II) a transfer element comprising:
(1) a second temporary support, and
(2) an adhesive layer.

7. The ink jet printing system according to claim 6,
**characterized in that** the adhesive layer of the transfer element comprises at least one thermoplastic polymer.

8. The ink jet printing system according to claims 6 - 7,
**characterized in that** the adhesive layer of the transfer element comprises at least one polymer selected from the group consisting of acrylate and methacrylate copolymers, vinyl acetate copolymers, and polyamides.

9. The ink jet printing system according to claims 6 - 8,
**characterized in that** the adhesive layer of the transfer element comprises at least one crystalline polymer.

10. The ink jet printing system according to claims 6 - 9,
**characterized in that** the adhesive layer of the transfer element comprises at least one polycaprolactone.

11. A process for preparing an image on a permanent substrate comprising the steps of:
(a) imagewise applying at least one ink image on an ink receptor sheet according to claims 1 - 5, whereby the ink image is adjacent the ink receiving layer
(b) contacting the imaged ink receptor sheet with a transfer element comprising:
(I) a second temporary support, and
(II) an adhesive layer, whereby the ink image is adjacent the adhesive layer;
(c) removing the second temporary support to reveal the adhesive layer on top of the imaged ink receptor sheet,
(d) contacting the imaged ink receptor sheet with a permanent substrate, whereby the adhesive layer is adjacent the permanent substrate,
(e) overall exposing with actinic radiation the permanent substrate and imaged ink receptor sheet sandwich through the first temporary support, and
(f) removing the first temporary support to reveal the final image on the permanent substrate, wherein the image is encased between the ink receiving layer and the adhesive layer.

12. The process according to claim 11,
**characterized in that** contacting comprises laminating.

13. The process according to claims 11 - 12,
**characterized in that** the overall exposure of step (e) is carried out before instead of after step (d).

14. The process according to claim 11 - 13,
**characterized in that** it further comprises the following additional process steps, in order, between steps (a) and (b):
(g) laminating a photosensitive layer to the imaged ink receiving layer of the ink receptor sheet,
(h) imagewise exposing the photosensitive layer with actinic radiation to produce tacky and non-tacky areas, and
(i) applying a toner to the tacky areas.

15. The process according to claim 14,
**characterized in that** the sequence of steps (g) to (i) is repeated at least once between steps (a) and (b).

16. The process according to claims 14 - 15,
**characterized in that** the photosensitive layer has a strippable base.

17. The process according to claims 14 - 16,
**characterized in that** the strippable base is removed before or after step (h).

18. The process according to claims 14 - 17,
**characterized in that** the photosensitive layer is a tacky, photopolymerizable layer.

19. The process according to claims 14 - 18,
**characterized in that** toner is selected from the group consisting of a pigmented toner powder and a pigmented foil in step (i).

20. A process for preparing an image on a permanent substrate comprising the steps of:
(a') imagewise applying at least one ink image on an ink receptor sheet according to claims 1 - 5,
(b') contacting the imaged ink receptor sheet with a element comprising:
(I) a permanent support, and
(II) an adhesive layer, whereby the ink image is adjacent the adhesive layer
(c') overall exposing the imaged ink receptor sheet through the first temporary support with actinic radiation, and
(d') removing the first temporary support to reveal the final image on the permanent substrate.

21. The process according to claim 20,
**characterized in that** it further comprises the process, in order, between steps (a') and (b'):
(g') laminating a photosensitive layer to the imaged ink receiving layer of the ink receptor sheet,
(h') imagewise exposing the photosensitive layer with actinic radiation to produce tacky and non-tacky areas, and
(i') applying a toner to the tacky areas.

22. The process according to claim 21,
**characterized in that** the sequence of steps (g') to (i') are repeated at least once between steps (a') and (b').

23. An imaged article comprising, in order:
(1) a permanent substrate,
(2) an adhesive layer,
(3) an ink image,
(4) an ink receiving layer, and
(5) a protective layer derived from a photopolymerizable layer comprising at least one polymeric binder, at least one photopolymerizable, ethylenically unsaturated monomer, and at least one photoinitiator or photoinitiator system.

24. The imaged article according to claim 23,
**characterized in that** the ink image is an ink jet image.

25. The imaged article according to claims 23 - 24,
**characterized in that** it comprises at least one toned layer prepared according to claims 14 - 19.

## Patentansprüche

1. Tintenempfangsmaterial enthaltend in dieser Reihenfolge:
(1) einen ersten temporären Schichtträger und
(2) eine Tintenempfangsschicht,
**dadurch gekennzeichnet, dass**
es außerdem zwischen dem ersten temporären Schichtträger und der Tintenempfangsschicht eine photopolymerisierbare Schicht enthält, die mindestens ein polymeres Bindemittel, mindestens ein photopolymerisierbares, ethylenisch ungesättigtes Monomer und mindestens einen Photoinitiator oder ein Photoinitiatorsystem enthält.

2. Tintenempfangsmaterial gemäß Anspruch 1,
**dadurch gekennzeichnet, dass**
die photopolymerisierbare Schicht mindestens ein polymeres Bindemittel enthält ausgewählt aus der Gruppe bestehend aus Polyvinylformal, Polyvinylbutyral, Polyvinylalkohol, Polyvinylacetat, Polyurethanestern Carboxylgruppen enthaltenden Polyacrylaten, Polymethacrylaten und Copolymeren von (Meth)acrylsäure mit (Meth)acrylsäureestern, (Meth)acrylsäureamiden, Vinyl-Verbindungen, Styrol und Butadien.

3. Tintenempfangsmaterial gemäß einem der Ansprüche 1 - 2,
**dadurch gekennzeichnet, dass**
die photopolymerisierbare Schicht mindestens ein Monomer enthält ausgewählt aus der Gruppe bestehend aus Trimethylolpropantrimethacrylat, Bisacrylaten oder -methacrylaten von Bisphenol A oder seinen alkoxylierten Derivaten und Pentaerythritoltetraacrylat oder - methacrylat.

4. Tintenempfangsmaterial gemäß einem der Ansprüche 1 - 3,
**dadurch gekennzeichnet, dass**
die Tintenempfangsschicht mindestens ein hydrophiles Polymer enthält.

5. Tintenempfangsmaterial gemäß einem der Ansprüche 1- 4,
**dadurch gekennzeichnet, dass**
die Tintenempfangsschicht mindestens ein Polymer enthält ausgewählt aus der Gruppe bestehend aus Homo- und Copolymeren von Vinylalkohol und/oder Pyrrolidon; Homo- und Copolymeren von Acrylsäure, Methacrylsäure, und/oder Maleinsäure und/oder Maleinsäureanhydride, und/oder ihrer Metallsalze und/oder ihrer Aminosalze; Gelatine und Stärke.

6. Tintenstrahldrucksystem umfassend die Kombination:
(I) ein Tintenempfangsmaterial gemäß einem der Ansprüche 1 - 5 und
(II) ein Übertragungselement umfassend:
(1) einen zweiten temporären Schichtträger, und
(2) eine Adhäsionschicht.

7. Tintenstrahldrucksystem gemäß Anspruch 6,
**dadurch gekennzeichnet, dass**
die Adhäsionschicht des Übertragungselement mindestens ein thermoplastisches Polymer enthält.

8. Tintenstrahldrucksystem gemäß einem der Ansprüche 6 - 7,
**dadurch gekennzeichnet, dass**
die Adhäsionschicht des Übertragungselement mindestens ein Polymer enthält ausgewählt aus der Gruppe bestehend aus Acrylat- and Methacrylatcopolymeren, Vinylacetatcopolymeren und Polyamiden.

9. Tintenstrahldrucksystem gemäß einem der Ansprüche 6 - 8,
**dadurch gekennzeichnet, dass**
die Adhäsionschicht des Übertragungselement mindestens ein kristallines Polymer enthält.

10. Tintenstrahldrucksystem gemäß einem der Ansprüche 6 - 9,
**dadurch gekennzeichnet, dass**
die Adhäsionschicht des Übertragungselement mindestens ein Polycaprolacton enthält.

11. Verfahren zur Herstellung eines Bildes auf einem permanenten Trägermaterial umfassend die Schritte:
(a) bildmäßiges Aufbringen mindestens eines Tintenbildes auf ein Tintenempfangsmaterial gemäß einem der Ansprüche 1 - 5, wobei das Tintenbild an die Tintenempfangsschicht angrenzt,
(b) Inkontaktbringen des bebilderten Tintenempfangsmaterials mit einem Übertragungselement umfassend:
(I) einen zweiten temporären Schichtträger, und
(II) eine Adhäsionschicht, wobei das Tintenbild an die Adhäsionsschicht angrenzt,
(c) Entfernen des zweiten temporären Schichtträger um die Adhäsionsschicht auf dem bebilderten Tintenempfangsmaterial freizulegen,
(d) Inkontaktbringen des bebilderten Tintenempfangsmaterials mit einem permanenten Trägermaterial, wobei die Adhäsionsschicht an das permanente Trägermaterial angrenzt,
(e) vollflächiges Belichten der Kombination aus permanentem Trägermaterial und bebildertem Tintenempfangsmaterial mit aktinischer Strahlung durch den ersten temporären Schichtträger, und
(f) Entfernen des ersten temporären Schichtträgers um das endgültige Bild auf dem permanenten Trägermaterial freizulegen, wobei das Bild zwischen der Tintenempfangsschicht und der Adhäsionschicht eingeschlossen ist.

12. Verfahren gemäß Anspruch 11,
**dadurch gekennzeichnet, dass**
Inkontaktbringen Laminieren umfasst.

13. Verfahren gemäß einem der Ansprüche 11 - 12,
**dadurch gekennzeichnet, dass**
die vollflächige Belichtung gemäß Schritt (e) vor anstatt nach Schritt (d) ausgeführt wird.

14. Verfahren gemäß einem der Ansprüche 11 - 13,
**dadurch gekennzeichnet, dass**
es außerdem zwischen den Schritten (a) and (b)die folgenden zusätzlichen Verfahrensschritte in dieser Reihenfolge umfasst:
(g) Laminieren einer photoempfindlichen Schicht auf die bebilderte Tintenempfangsschicht des Tintenempfangsmaterials,
(h) bildmäßiges Belichten der photoempfindlichen Schicht mit aktinischer Strahlung um klebrige und nicht klebrige Bereiche zu erzeugen und
(i) Aufbringen eines Toners auf die klebrigen Bereiche.

15. Verfahren gemäß Anspruch 14,
**dadurch gekennzeichnet, dass**
die Reihenfolge der Schritte (g) to (i) mindestens einmal zwischen den Schritten (a) and (b) wiederholt wird.

16. Verfahren gemäß einem der Ansprüche 14 - 15,
**dadurch gekennzeichnet, dass**
die photoempfindliche Schicht einen abziehbaren Träger hat.

17. Verfahren gemäß einem der Ansprüche 14 - 16,
**dadurch gekennzeichnet, dass**
der abziehbaren Träger vor oder nach Schritt (h) abgezogen wird.

18. Verfahren gemäß einem der Ansprüche 14 - 17,
**dadurch gekennzeichnet, dass**
die photoempfindliche Schicht eine photopolymerisierbare Schicht ist.

19. Verfahren gemäß einem der Ansprüche 14 - 18,
**dadurch gekennzeichnet, dass**
der Toner in Schritt (i) aus der Gruppe bestehend aus einem pigmentierten Tonerpulver und einer pigmentierten Folie ausgewählt wird.

20. Verfahren zur Herstellung eines Bildes auf einem permanenten Trägermaterial umfassend die Schritte:
(a') bildmäßiges Aufbringen mindestens eines Tintenbildes auf ein Tintenempfangsmaterial gemäß einem der Ansprüche 1 - 5,
(b') Inkontaktbringen des bebilderten Tintenempfangsmaterials mit einem Element umfassend:
(I) einen permanenten Schichtträger, und
(II) eine Adhäsionschicht, wobei das Tintenbild an die Adhäsionsschicht angrenzt,
(c') vollflächiges Belichten des bebilderten Tintenempfangsmaterials mit aktinischer Strahlung durch den ersten temporären Schichtträger und
(d') Entfernen des ersten temporären Schichtträgers um das endgültige Bild auf dem permanenten Trägermaterial.

21. Verfahren gemäß Anspruch 20,
**dadurch gekennzeichnet, dass**
es außerdem zwischen den Schritten (a') and (b')den folgenden Prozess in dieser Reihenfolge umfasst:
(g') Laminieren einer photoempfindlichen Schicht auf die bebilderte Tintenempfangsschicht des Tintenempfangsmaterials,
(h') bildmäßiges Belichten der photoempfindlichen Schicht mit aktinischer Strahlung um klebrige und nicht klebrige Bereiche zu erzeugen und
(i') Aufbringen eines Toners auf die klebrigen Bereiche.

22. Prozess gemäß Anspruch 21,
**dadurch gekennzeichnet, dass**
die Reihenfolge der Schritte (g') to (i') mindestens einmal zwischen den Schritten (a') and (b') wiederholt wird.

23. Bebilderter Artikel umfassend in dieser Reihenfolge:
(1) ein permanentes Trägermaterial,
(2) eine Adhäsionsschicht,
(3) ein Tintenbild,
(4) eine Tintenempfangsschicht, und
(5) eine Schutzschicht hergestellt aus einer photopolymerisierbaren Schicht enthaltend mindestens ein polymeres Bindemittel, mindestens ein photopolymerisierbares, ethylenisch ungesättigtes Monomer und mindestens einen Photoinitiator oder ein Photoinitiatorsystem.

24. Bebilderter Artikel gemäß Anspruch 23,
**dadurch gekennzeichnet, dass**
das Tintenbild ein Tintenstrahlbild ist.

25. Bebilderter Artikel gemäß einem der Ansprüche 23 - 24,
**dadurch gekennzeichnet, dass**
er mindestens eine getonte Schicht hergestellt gemäß einem der Ansprüche 14 - 19 enthält.

## Revendications

1. Feuille de récepteur d'encre comprenant, dans l'ordre:
(1) un premier support temporaire; et
(2) une couche de réception d'encre,
**caractérisée en ce qu'**elle comprend en outre une couche photopolymérisable qui comprend au moins un agent de liaison polymérique, au moins un monomère non saturé éthyléniquement photopolymérisable et au moins un photo-initiateur ou un système de photo-initiateur entre le premier support temporaire et la couche de réception d'encre.

2. Feuille de récepteur d'encre selon la revendication 1, **caractérisée en ce que** la couche photopolymérisable comprend au moins un agent de liaison polymérique choisi parmi le groupe comprenant polyvinylformal, polyvinyl butyral, alcool polyvinylique, acétate de polyvinyle, esters polyuréthanes, polyacrylates contenant des groupes carboxyliques, polyméthacrylates et copolymères d'acide (méth)acrylique avec des esters (méth)acryliques, des amides (méth)acryliques, des composés vinyliques, styrène et butadiène.

3. Feuille de récepteur d'encre selon les revendications 1 et 2, **caractérisée en ce que** la couche photopolymérisable comprend au moins un monomère choisi parmi le groupe comprenant triméthacrylate de triméthylol propane, bisacrylate ou méthacrylate de bisphénol A ou ses dérivés alkoxylatés et tétra-acrylate ou méthacrylate de pentaérythritol.

4. Feuille de récepteur d'encre selon les revendications 1 à 3, **caractérisée en ce que** la couche de réception d'encre comprend au moins un polymère hydrophile.

5. Feuille de récepteur d'encre selon les revendications 1 à 4, **caractérisée en ce que** la couche de réception d'encre comprend au moins un polymère choisi parmi le groupe comprenant des homo et des copolymères d'alcool vinylique et/ou de pyirolidone; des homo et des copolymères d'acide acrylique, d'acide méthacrylique et/ou d'acide maléique et/ou d'anhydride d'acide maléique et/ou de leurs sels métalliques et/ou de leurs sels amine; gélatine et amidon.

6. Système d'impression à jet d'encre comprenant, en combinaison:
(I) une feuille de récepteur d'encre selon les revendications 1 à 5; et
(II) un élément de transfert comprenant:
(1) un second support temporaire; et
(2) une couche adhésive.

7. Système d'impression à jet d'encre selon la revendication 6, **caractérisé en ce que** la couche adhésive de l'élément de transfert comprend au moins un polymère thermoplastique.

8. Système d'impression à jet d'encre selon les revendications 6 et 7, **caractérisé en ce que** la couche adhésive de l'élément de transfert comprend au moins un polymère choisi parmi le groupe comprenant des copolymères d'acrylate et de méthacrylate, des copolymères d'acétate de vinyle et des polyamides.

9. Système d'impression à jet d'encre selon les revendications 6 à 8, **caractérisé en ce que** la couche adhésive de l'élément de transfert comprend au moins un polymère cristallin.

10. Système d'impression à jet d'encre selon les revendications 6 à 9, **caractérisé en ce que** la couche adhésive de l'élément de transfert comprend au moins un polycaprolactone.

11. Procédé pour préparer une image sur un substrat permanent, comprenant les étapes de:
(a) application dans le sens de l'image d'au moins une image d'encre sur une feuille de récepteur d'encre selon les revendications 1 à 5 et ainsi, l'image d'encre est adjacente à la couche de réception d'encre;
(b) mise en contact de la feuille de récepteur d'encre imagée avec un élément de transfert comprenant:
(I) un second support temporaire; et
(II) une couche adhésive et ainsi, l'image d'encre est adjacente à la couche adhésive;
(c) enlèvement du second support temporaire afin de révéler la couche adhésive sur le sommet de la feuille de récepteur d'encre imagée;
(d) mise en contact de la feuille de récepteur d'encre imagée avec un substrat permanent et ainsi, la feuille adhésive est adjacente au substrat permanent;
(e) exposition globale à l'aide d'un rayonnement actinique du sandwich constitué par le substrat permanent et par la feuille de récepteur d'encre imagée par l'intermédiaire du premier support temporaire; et
(f) enlèvement du premier support temporaire afin de révéler l'image finale sur le substrat permanent, où l'image est logée entre la couche de réception d'encre et la couche adhésive.

12. Procédé selon la revendication 11, **caractérisé en ce que** la mise en contact comprend un empilement.

13. Procédé selon les revendications 11 et 12, **caractérisé en ce que** l'exposition globale de l'étape (e) est mise en oeuvre avant au lieu de après l'étape (d).

14. Procédé selon les revendications 11 à 13, **caractérisé en ce qu'**il comprend en outre les étapes de processus additionnelles qui suivent, dans l'ordre, entre les étapes (a) et (b):
(g) empilement d'une couche photosensible sur la couche de réception d'encre imagée de la feuille de récepteur d'encre;
(h) exposition dans le sens de l'image de la couche photosensible à l'aide d'un rayonnement actinique afin de produire des zones collantes et non collantes; et
(i) application d'un toner sur les zones collantes.

15. Procédé selon la revendication 14, **caractérisé en ce que** la séquence des étapes (g) à (i) est répétée au moins une fois entre les étapes (a) et (b).

16. Procédé selon les revendications 14 et 15, **caractérisé en ce que** la couche photosensible est une base enlevable.

17. Procédé selon les revendications 14 à 16, **caractérisé en ce que** la base enlevable est enlevée avant ou après l'étape (h).

18. Procédé selon les revendications 14 à 17, **caractérisé en ce que** la couche photosensible est une couche photopolymérisable collante.

19. Procédé selon les revendications14 à 18, **caractérisé en ce qu'**un toner est choisi parmi le groupe comprenant une poudre de toner pigmentée et une feuille pigmentée au niveau de l'étape (i).

20. Procédé pour préparer une image sur un substrat permanent, comprenant les étapes de:
(a') application dans le sens de l'image d'au moins une image d'encre sur une feuille de récepteur d'encre selon les revendications 1 à 5;
(b') mise en contact de la feuille de récepteur d'encre imagée avec un élément comprenant:
(I) un support permanent ; et
(II) une couche adhésive et ainsi, l'image d'encre est adjacente à la couche adhésive;
(c') exposition globale de la feuille de récepteur d'encre imagée par l'intermédiaire du premier support temporaire à l'aide d'un rayonnement actinique; et
(d') enlèvement du premier support temporaire afin de révéler l'image finale sur le substrat permanent.

21. Procédé selon la revendication 20, **caractérisé en ce qu'**il comprend en outre le procédé, dans l'ordre, entre les étapes (a') et (b'), de:
(g') empilement d'une couche photosensible sur la couche de réception d'encre imagée de la feuille de récepteur d'encre;
(h') exposition dans le sens de l'image de la couche photosensible à l'aide d'un rayonnement actinique afin de produire des zones collantes et non collantes; et
(i') application d'un toner sur les zones collantes.

22. Procédé selon la revendication 21, **caractérisé en ce que** la séquence des étapes (g') à (i') est répétée au moins une fois entre les étapes (a') et (b').

23. Article imagé comprenant, dans l'ordre:
(1) un substrat permanent;
(2) une couche adhésive;
(3) une image d'encre;
(4) une couche de réception d'encre; et
(5) une couche de protection qui est dérivée à partir d'une couche polymérisable comprenant au moins un agent de liaison polymérique, au moins un monomère non saturé éthyléniquement photopolymérisable et au moins un photo-initiateur ou un système de photo-initiateur.

24. Article imagé selon la revendication 23, **caractérisé en ce que** l'image d'encre est une image à jet d'encre.

25. Article imagé selon les revendications 23 et 24, **caractérisé en ce qu'**il comprend au moins une couche de toner préparée selon les revendications 14 à 19.
